(19) Europäisches Patentamt
European Patent Office
Office européen des brevets

(11) **EP 2 775 625 B1**

(12) **EUROPÄISCHE PATENTSCHRIFT**

(45) Veröffentlichungstag und Bekanntmachung des Hinweises auf die Patenterteilung:
**13.06.2018   Patentblatt 2018/24**

(51) Int Cl.:
***H03K 17/975*** (2006.01)

(21) Anmeldenummer: **14155859.3**

(22) Anmeldetag: **20.02.2014**

(54) **Kapazitiver Positionsschalter**

Capacitive position switch

Capteur de position capacitif

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.03.2013   DE 102013102237**

(43) Veröffentlichungstag der Anmeldung:
**10.09.2014   Patentblatt 2014/37**

(73) Patentinhaber: **K.A. Schmersal Holding GmbH & Co. KG**
**42279 Wuppertal (DE)**

(72) Erfinder: **Langerfeld, Ralf**
**42499 Hückeswagen (DE)**

(74) Vertreter: **Kalkoff & Partner Patentanwälte**
**Martin-Schmeisser-Weg 3a-3b**
**44227 Dortmund (DE)**

(56) Entgegenhaltungen:
**DE-A1-102007 038 225     US-A1- 2009 086 879**

**Beschreibung**

Die Erfindung betrifft einen Positionsschalter zur Erfassung eines beweglichen Targets innerhalb eines Erfassungsbereiches. Weiter betrifft die Erfindung als Anwendungen eines solchen Positionsschalters eine Hubvorrichtung einer beweglichen Hubeinheit, eine Fördervorrichtung mit einem beweglichen Element, eine Vorrichtung mit einem Schwenkarm, eine Vorrichtung mit einer beweglichen Tür und eine Verriegelungsvorrichtung mit einem beweglichen Bolzen.

Erfassungsvorrichtungen zur Erfassung eines beweglichen Targets innerhalb eines Erfassungsbereichs sind im Stand der Technik vielfältig bekannt, bspw. als Positions- oder Wegsensoren, mit denen die exakte Position eines beweglichen Targets entlang einer Wegstrecke erfasst werden kann. Hierfür gibt es insbesondere in der Sicherheit- und Automatisierungstechnik vielfältige Anwendungen.

Beispielsweise beschreibt die DE 10207017 A1 eine Vorrichtung zur Messung der Hubhöhe einer Lasttrageeinrichtung eines Flurförderfahrzeugs. An einem Gabelstapler ist ein Hubgerüst mit einem Standmast zur Auf- und Abbewegung eines Gabelträgers vorgesehen. Ein linienförmiger Messwertaufnehmer am Standmast weist einen Messbereich auf, der im Wesentlichen der Profilhöhe des Standmastes entspricht. Am Gabelträger ist ein kabelloser Positionsgeber befestigt, der im eingefahrenen Zustand des Hubgerüstes bei einer Auf- und Abbewegung am Messwertaufnehmer berührungslos entlang bewegt wird und mit dessen Hilfe die Ausfahrposition ermittelt wird. Bei einem Triplex-Hubgerüst mit innerem und mittlerem Hubmast sind mehrere Positionsgeber vorgesehen, wobei durch Addition der Wegstrecken die Hubhöhe ermittelt wird. Als Messverfahren kommen induktivpotentiometrische oder magnetostriktive Systeme in Frage.

Die DE 10 2007 038 225 A1 beschreibt ein kapazitives Messsystem mit einer Anzahl von baugleichen kapazitiven Sensoren zur Erfassung verschiedener Messobjekte sowie einen Referenzsensor mit fester Ankopplung an ein Schutzleiterpotential. Ein Generator erzeugt eine Wechselgröße als Anregungssignal für die Sensoren. Die Ausgangssignale der Sensoren werden identischen Verstärkerkanälen zugeführt. Eine Auswerteeinrichtung umfasst eine Schaltungseinrichtung zum Verarbeiten der Ausgangssignale und eines festen Sollwerts, die ein Stellsignal generiert, welches dem Anregungsgenerator zur Modulation des Anregungssignals zugeführt wird.

Während ein solcher Positions- bzw. Wegsensor es ermöglicht, die exakte Position des beweglichen Targets innerhalb eines Messbereiches zu ermitteln, reichen für viele Anwendungen bereits Positionsschalter aus, mit denen lediglich die An- oder Abwesenheit des Targets innerhalb eines Erfassungsbereichs ermittelbar ist.

In der DE 100 51 292 A1 ist ein kapazitiver Näherungsschalter beschrieben mit zwei Signalsendern und einem Signalempfänger. Die Signalsender sind jeweils mit Signalübertragungswegen verbunden, in denen sich Kapazitäten befinden, von denen eine der Kapazitäten eine Ansprechkapazität und die andere eine Referenzkapazität bilden kann. Die Referenzkapazität kann als Kondensator ausgeführt sein.

Die EP 1 152 533 A1 beschreibt einen kapazitiven oder induktiven Näherungssensor mit einem Oszillator, der ein Messsignal abgibt, dessen Frequenz eine Funktion der Annäherung eines Objektes an den Detektor ist. Eine Verarbeitungsschaltung gibt ein Ausgangssignal abhängig von der Frequenz des Oszillators ab.

Die US 2009/0086879 A1 beschreibt eine Sensorvorrichtung die eine relative Position eines ersten Gliedes und zweiten Gliedes erfasst. Eine Signalquelle erzeugt ein elektrisches Signal, eine erste Elektrode empfängt das elektrische Signal und speichert eine elektrische Ladung am ersten Glied. Eine zweite Elektrode induziert eine elektrische Ladung am zweiten Glied. Eine dritte Elektrode induziert eine elektrische Ladung am zweiten Glied. Eine vierte Elektrode induziert eine elektrische Ladung am ersten Glied. Eine Referenzelektrode am zweiten Glied ist mit einem Referenzspannungspunkt verbunden. Eine fünfte Elektrode induziert eine elektrische Ladung am ersten Glied, und ein Differenzverstärker verstärkt eine Differenzspannung zwischen der vierten Elektrode und der fünften Elektrode, um ein Differenzsignal auszugeben.

Es ist Aufgabe der Erfindung, einen Positionsschalter vorzuschlagen, mit dem eine besonders betriebssichere Erfassung des Targets innerhalb eines Erfassungsbereiches ermöglicht wird.

Diese Aufgabe wird gelöst durch einen Positionsschalter gemäß Anspruch 1, eine Hubvorrichtung gemäß Anspruch 10, eine Fördervorrichtung gemäß Anspruch 11, eine Vorrichtung mit einem Schwenkarm gemäß Anspruch 12, eine Vorrichtung mit einer beweglichen Tür gemäß Anspruch 13 und durch eine Verriegelungsvorrichtung mit einem beweglichen Bolzen gemäß Anspruch 14. Abhängige Ansprüche beziehen sich auf vorteilhafte Ausführungsformen der Erfindung.

Beim erfindungsgemäßen Positionsschalter ist ein Target innerhalb eines Spaltes verschiebbar. Über mindestens einen Teil der Länge des Spalts ist zumindest ein Erfassungsbereich definiert, wobei die Aufgabe des Positionsschalters darin besteht, die Anwesenheit des Targets innerhalb des Erfassungsbereiches anzuzeigen bzw. ebenso anzuzeigen, falls sich das Target nicht innerhalb des Erfassungsbereiches befindet. Die Spaltlänge kann mit der Länge des Erfassungsbereichs übereinstimmen, so dass jede Anwesenheit des Targets im Spalt, gleich an welcher Position, detektiert wird. In einigen Ausführungen weist der Spalt aber insgesamt eine größere Länge als der Erfassungsbereich auf, so dass außerhalb des Erfassungsbereiches auch mindestens ein Nicht-Erfassungsbereich gebildet ist, in den das Target innerhalb des Spaltes verschoben werden kann und sich dann außerhalb des Erfassungsbereiches befindet. Diese Grundkonstellation eines in einem Spalt mindestens zwischen einem Erfassungsbereich und einem Nicht-Erfassungsbereich verschieblichen Targets ist, wie nachfolgend an mehreren Beispielen erläutert wird, für eine Vielzahl von Anwendungen insbesondere in der Sicherheits- und Automatisierungstechnik verwendbar.

Die Erkennung des Targets erfolgt erfindungsgemäß nach einem kapazitiven Messprinzip, wobei innerhalb des Erfassungsbereiches mindestens eine Referenzelektrode und eine Erfassungselektrode vorgesehen sind. Diese bilden über dem Spalt mit Gegenelektroden mindestens eine Referenzkapazität und Erfassungskapazität. Die Elektroden sind bevorzugt zum Spalt hin flächenförmig, so dass die Erfassungs- und Referenzkapazität bevorzugt nach Art eines Plattenkondensators gebildet sind. Die Gegenelektroden können jeweils einzeln gegenüber der Referenz- und Erfassungselektrode angeordnet sein, bevorzugt sind sie als gemeinsame Basiselektrode zusammengefasst. Wie nachfolgend näher erläutert wird können zusätzliche Elektroden und Kapazitäten vorgesehen sein, insbesondere sowohl zusätzliche Referenz- als auch zusätzliche Erfassungskapazitäten. Eine besonders bevorzugte Ausführung umfasst mindestens eine Referenzelektrode und mindestens zwei Erfassungselektroden.

In Zuordnung zur Anordnung der Elektroden seitlich am Spalt weist das Target einen Referenzteil und einen Erfassungsteil auf. So ist bevorzugt zwischen Referenzelektrode und Gegenelektrode der Referenzteil und zwischen Erfassungselektrode und Gegenelektrode der Erfassungsteil des Targets angeordnet. Referenzteil und Erfassungsteil des Targets sind dabei hinsichtlich der Beeinflussung eines elektrischen Feldes unterschiedlich ausgebildet, so dass sie die jeweils zugeordnete Kapazität bei Anordnung im Spalt zwischen den Elektroden unterschiedlich beeinflussen, d.h. den Kapazitätswert verändern. Eine solche unterscheidbare Veränderung des Kapazitätswerts erfolgt bspw. bereits dann, wenn Referenzteil und Erfassungsteil unterschiedliche dielektrische Eigenschaften aufweisen. Wie nachfolgend erläutert wird kommt es zu einer besonders deutlich unterschiedlichen Beeinflussung der Kapazität, wenn einer der Teile mindestens überwiegend als Dielektrikum ausgebildet ist und der andere Teil mindestens überwiegend als elektrischer Leiter.

Mittels einer Auswertungsschaltung wird die Differenz von Kapazitätswerten der Referenzkapazität und der Erfassungskapazität ermittelt und ausgewertet. Dabei wird die Anwesenheit des Targets innerhalb des Erfassungsbereichs aufgrund der unterschiedlichen Beeinflussung der Kapazitätswerte der Referenzkapazität und der Erfassungskapazität erkennbar, so dass die Auswertungsschaltung unterscheiden kann zwischen einem Zustand ohne Anwesenheit des spezifischen Targets mit seinem Referenz- und Erfassungsteil und einem Zustand ohne dessen Anwesenheit. Entsprechend kann die Auswertungsschaltung ein Erfassungssignal abgeben. Das Erfassungssignal beruht mindestens auf Bildung der oben genannten Differenz von Kapazitätswerten und kann - je nach Ausführung und Anforderungen - noch zusätzlich durch weitere Signalverarbeitung beeinflusst sein, bspw. durch verschiedene Verstärkungen, Vergleich mit Schwellwerten, Plausibilisierungen, logischen Verknüpfungen etc. In jedem Fall aber ist ein Schritt der Ermittlung des Erfassungssignals die Bildung der Differenz von Kapazitätswerten der Referenzkapazität und der Erfassungskapazität, so dass sich stets die oben angegebenen Vorteile einstellen.

Das Erfassungssignal kann im Prinzip in beliebiger Form ausgegeben werden, d.h. bspw. als Digitalsignal oder analoges Strom- bzw. Spannungssignal. Es kann in Form eines kontinuierlichen Messwertes abgegeben werden, bspw. proportional zur Differenz der Kapazitätswerte. Besonders bevorzugt ist aber die Abgabe eines Erfassungssignals als Logiksignal, das lediglich zwei Zustände annimmt und somit entweder anzeigt, dass das Target innerhalb des Erfassungsbereichs erkannt wurde oder nicht. (Ergänzend kann im Fall eines Fehlers bzw. eines Manipulationsversuches zusätzlich noch ein Fehlerzustand signalisiert werden.)

Der erfindungsgemäße Positionsschalter ermöglicht einen sehr einfachen Aufbau der Erfassungsvorrichtung einerseits und der Auswertungsschaltung andererseits. Bevorzugt erfolgt die Erfassung berührungslos. Insbesondere kann er mechanisch und elektrisch besonders robust realisiert werden. Besondere Vorteile resultieren aus der Bildung der Differenz von Kapazitätswerten. Hierdurch wird die Erfassung robust gegenüber Störungen, bspw. durch magnetische und elektrische Felder. Diese werden aufgrund ihrer räumlichen Ausdehnung die Erfassung- und die Referenzkapazität in mindestens annähernd gleichem Maße beeinflussen, so dass derartige Störungen bereits prinzipbedingt eliminiert werden. Ein weiterer Vorteil, der insbesondere im sicherheitstechnischen Bereich relevant ist, ist durch die vorgegebene räumlich/elektrische Ausgestaltung des Targets mit vorgegebener Anordnung von Referenz- und Erfassungsteil, die auch als Kodierung verstanden werden kann, eine Erkennung von Fehlerzuständen und Manipulationen.

Gemäß einer Weiterbildung der Erfindung ist mindestens eine erste und eine zweite Erfassungselektrode und dementsprechend eine erste und zweite Erfassungskapazität vorgesehen. In entsprechender räumlicher Zuordnung weist das Target zwei Erfassungsteile auf, wobei besonders bevorzugt die beiden Erfassungsteile gleich ausgebildet sind, so dass sie den Kapazitätswert der ersten und zweiten Kapazität bei passender Anordnung im Spalt in gleicher Weise beeinflussen. Die Auswertung erfolgt dann bevorzugt so, dass eine erste Differenz von Kapazitätswerten der Referenzkapazität und der ersten Erfassungskapazität und eine zweite Differenz von Kapazitätswerten der Referenzkapazität und der zweiten Erfassungskapazität erfolgen.

Hierdurch wird die Erfassung robuster und es ergeben sich weitere Überprüfungsmöglichkeiten so dass insbesondere Fehler und Manipulationsversuche erkannt werden können.

Besonders bevorzugt ist eine Auswertung, bei der ein Vergleich der Kapazitätswerte (oder, äquivalent hierzu, ein Vergleich der Differenzkapazitäten) der ersten und zweiten Erfassungskapazität vorgenommen wird. Bei einer Abweichung oberhalb einer wählbaren Schwelle kann die Auswertungsschaltung einen Fehlerzustand melden.

Weiter ist es möglich, entlang des Spalts mehrere voneinander getrennte oder sogar überlappende Erfassungsbereiche vorzusehen. So kann ermittelt werden, in welchem von mehren Bereichen sich das Target befindet.

Die Ausgestaltung und Anordnung der Elektroden am Schlitz erfolgt bevorzugt so, dass die Referenzkapazität ohne Anwesenheit des Targets im Wesentlichen (d.h. mit geringer Abweichung von nicht mehr als +/- 15%, bevorzugt nicht mehr als +/- 5%) gleichen Kapazitätswert aufweist wie die Erfassungskapazität (oder im Fall von mehreren Erfassungselek-troden wie die Erfassungskapazitäten). Dann ergibt sich ohne Anwesenheit des Targets ein Differenzwert nahe Null, während durch die Beeinflussung des Kapazitätswerts bei Anwesenheit des Targets ein höherer Differenzwert auftritt. Bevorzugt kann in diesem Fall die Detektion des Targets durch Vergleich des Differenzwerts mit einem geeigneten Schwellenwert erfolgen.

In einer bevorzugten Ausgestaltung sind die Referenzelektrode und die Erfassungselektrode(n) jeweils als Streifen gleicher Form und Abmessungen gebildet, die sich in Längsrichtung des Schlitzes erstrecken. Besonders bevorzugt ist dabei, dass die Referenzelektrode zwischen einer ersten und einer zweiten Erfassungselektrode angeordnet ist. So ist insbesondere eine hohe Störsicherheit gegeben.

Andere Weiterbildungen der Erfindung betreffen die Ausgestaltung des Targets. Bevorzugt weist dieses am Erfassungsteil eine Zwischenelektrode auf, d.h. einen elektrischen Leiter. Dieser kann bspw. die gesamte Breite der zugeordneten Erfassungselektrode aufweisen, so dass der gesamte Erfassungsteil als Elektrode ausgebildet ist. Hingegen ist bevorzugt, dass im Referenzteil des Targets keine Zwischenelektrode angeordnet ist. Dort kann ein Dielektrikum vorgesehen sein; bevorzugt wird der Referenzteil des Targets überwiegend, d.h. bis auf Verbindungselemente, frei bleiben, so dass eine Aussparung als Dielekrikum dazu führt, dass die Referenzkapazität unabhängig von der Anwesenheit des Targets im Wesentlichen einen gleichbleibenden Kapazitätswert aufweist.

Weitere Änderungen und Ausgestaltungen des erfindungsgemäßen Positionsschalters sind für den Fachmann aus den nachfolgenden Ausführungsbeispielen ersichtlich.

Für einen erfindungsgemäßen Positionsschalter sind verschiedenste Anwendungen denkbar.

Bei einer Hubvorrichtung mit einer beweglichen Hubeinheit kann ein Positionsschalter vorgesehen sein, um festzustellen ob sich die Hubeinheit in einem bestimmten, durch den Erfassungsbereich festgelegten Höhenbereich befindet. Dann ist bevorzugt die Hubeinheit so mit dem Target gekoppelt, dass es sich bei Bewegung der Hubeinheit entlang des Schlitzes bewegt. Das Erfassungssignal zeigt dann an, ob das Target innerhalb des Erfassungsbereiches und damit die Hubeinheit innerhalb des festgelegten Höhenbereiches angeordnet ist. So kann bspw. eine Drosselung eines Flurförderfahrzeugs erfolgen, sobald die Last oberhalb einer festgelegten Schwelle gehoben ist.

In einer alternativen Anwendung eines Positionsschalters ist ein Schwenkarm vorgesehen. Durch das Erfassungssignal soll angezeigt werden, ob die Schwenkposition des Schwenkarms noch innerhalb eines festgelegten, zulässigen Schwenkbereichs oder bereits außerhalb liegt. Hierzu erstreckt sich der Schlitz des erfindungsgemäßen Positionsschalters entlang einer bogenförmigen Bahn und der Schwenkarm ist mit dem Target so gekoppelt, dass es sich beim Schwenken des Arms entlang des Schlitzes bewegt. Der Erfassungsbereich legt den erlaubten Schwenkbereich fest. Dann zeigt das Erfassungssignal an, ob sich das Target innerhalb des Erfassungsbereiches und damit der Arm innerhalb des Schwenkbereiches befindet.

In einer weiteren alternativen Anwendung ist eine bewegliche, bevorzugt verschiebbare Tür mit dem Target so gekoppelt, dass es sich bei Bewegung der Tür entlang des Schlitzes bewegt. Ein Öffnungs- oder Schließbereich ist festgelegt dadurch, dass sich bei einer Position der Tür innerhalb des Bereiches das damit gekoppelte Target innerhalb des Erfassungsbereiches befindet. So kann mittels der Auswertungsschaltung festgestellt werden, ob sich die Tür in dem fraglichen Öffnungs- oder Schließbereich befindet.

Schließlich ist der erfindungsgemäße Positionsschalter im Rahmen einer Verriegelungsvorrichtung mit einem beweglichen Bolzen, insbesondere einem Riegelbolzen verwendbar. Dabei kann der Bolzen mit dem Target gekoppelt sein, bevorzugt kann der Bolzen selbst als Target ausgebildet sein. Bei Bewegung des Bolzens zwischen einer Offenstellung und einer Riegelstellung bewegt sich somit das Target entlang des Schlitzes. Der Erfassungsbereich des Positionsschalters ist dann so angeordnet, dass er der Offenstellung oder der Riegelstellung zugeordnet ist, so dass das Erfassungssignal die entsprechende Stellung des Bolzens anzeigt.

Nachfolgend werden Ausführungsformen der Erfindung anhand der Zeichnungen näher beschrieben. Hierbei zeigen:

Fig. 1 in teilweise schematischer Seitenansicht eine Ausführungsform eines Positionsschalters;

Fig. 2 eine Schnittansicht des Positionsschalters aus Fig. 1 mit dem Schnitt entlang der Linie A..A;

Fig.3    eine schematische Darstellung von Funktionseinheiten des Positionsschalters aus Fig.1, Fig. 2;

Fig. 4    in schematischer Darstellung die Zusammenfügung von Segmenten einer Sensorleiste des Positionsschalters aus Fig. 1 - Fig. 3;

Fig. 5 - Fig. 8    in jeweils schematischer Darstellung Anwendungen eines Positionsschalters als Hubvorrichtung, Fördervorrichtung, Schwenkarmüberwachung und Türüberwachung.

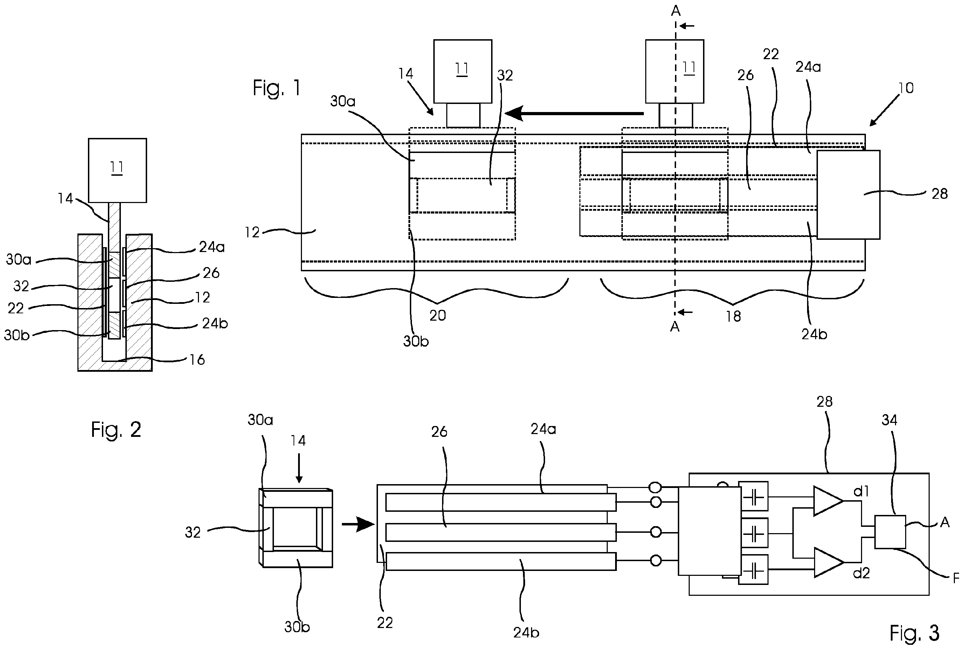

Fig. 1 zeigt in Seitenansicht einen Positionsschalter 10, der eine Sensorleiste 12 und ein gegenüber dieser bewegliches Target 14 umfasst. Wie aus der Schnittansicht Fig.2 ersichtlich erstreckt sich in Längsrichtung der Sensorleiste 12 ein Schlitz 16, entlang dessen das Target 14 verschiebbar ist.

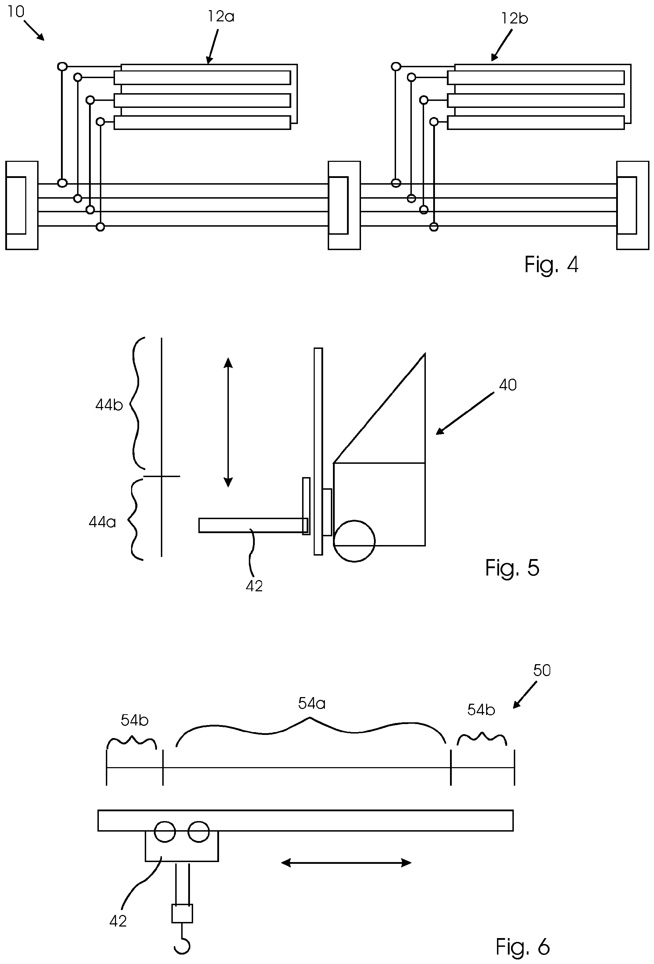

Das Target 14 ist an einem nur schematisch gezeigten Bewegungsglied 11 angebracht. Mit Hilfe des Positionsschalters 10 wird die Bewegung des Bewegungsgliedes 11 gegenüber der Sensorleiste 12 erfasst. Anwendungsbeispiele mit verschiedenen Bewegungsgliedern werden im Zusammenhang mit Fig. 4 -8 erläutert.

Die Sensorleiste 12 ist im vorliegenden Beispiel in ihrer Länge unterteilt in einen Erfassungsbereich 18 und einen Nicht-Erfassungsbereich 20. Der Positionsschalter 10 dient dazu, festzustellen, ob sich das Target 14 - und somit das Bewegungsglied 11 - an einer Position innerhalb der Sensorleiste 12 im Erfassungsbereich 18 oder außerhalb hiervon befindet.

Hierfür sind beidseits des Schlitzes 16 Elektroden angeordnet, die verschiedene Kapazitäten bilden. Wie aus Fig. 1, Fig. 2 ersichtlich ist innerhalb des Erfassungsbereiches 18 auf einer Seite des Schlitzes 16 eine durchgehende plattenförmige Basiselektrode 22 angeordnet. Auf der gegenüberliegenden Seite befinden sich untereinander streifenförmige Elektroden in Form einer ersten Erfassungselektrode 24a, einer zweiten Erfassungselektrode 24b und dazwischen einer Referenzelektrode 26. Die Elektroden 22, 24a, 24b, 26 erstrecken sich in Längsrichtung der Sensorleiste 12 nur im Erfassungsbereich 18. Sie sind jeweils an eine Auswertungsschaltung 28 angeschlossen.

Elektrisch bilden die im Spalt 16 gegenüberliegenden Elektroden verschiedene Kapazitäten in Form von Plattenkondensatoren. Die erste Erfassungselektrode 24a bildet mit der Basiselektrode 22 eine erste Erfassungskapazität, die zweite Erfassungselektrode 24b bildet mit der Basiselektrode eine zweite Erfassungskapazität und die Referenzelektrode 26 bildet mit der Basiselektrode 22 eine Referenzkapazität.

Dabei sind die Referenz- und Erfassungselektroden 24a, 24b, 26 gleich ausgebildet, so dass der Kapazitätswert von Referenz- und Erfassungskapazitäten im ungestörten Zustand im Wesentlichen gleich ist.

Durch Anwesenheit des Targets 14 im Spalt 16 zwischen den Elektroden wird dieses Gleichgewicht gestört. Das Target 14 umfasst, räumlich den Elektroden zugeordnet, einen ersten Erfassungsteil 30a, eine zweiten Erfassungsteil 30b und einen dazwischen angeordneten Referenzteil 32. Der erste und zweite Erfassungsteil 30a, 30b besteht aus leitfähigem Metall und bildet somit im Spalt 16 eine Zwischenelektrode zwischen den gegenüberliegenden Elektroden der ersten und zweiten Erfassungskapazität. Hierdurch verändert sich bei Anordnung des Targets 14 im Erfassungsbereich 18 der Kapazitätswert der ersten und zweiten Erfassungskapazität.

Im Gegensatz hierzu umfasst der Referenzteil 32 des Targets 14 keinen Leiter, sondern besteht im Wesentlichen aus einer luftgefüllten Aussparung (wobei der erste und zweite Erfassungsteil 30a, 30b im Abstand voneinander durch verbindende Halter gehalten werden. Diese bestehen aus dielektrischem Material.) Somit ändert sich durch Anwesenheit des Targets 14 innerhalb des Spalts 16 im Erfassungsbereich 18 der Kapazitätswert der Referenzkapazität nicht (bzw. nur in sehr geringem Maße durch die dielektrischen Verbinder).

Die Elektroden sind an eine Auswertungsschaltung 28 angeschlossen. Fig. 3 zeigt schematisch deren Aufbau.

Die Auswertungsschaltung 28 bestimmt zunächst Kapazitätswerte für die Referenzkapazität und erste und zweite Erfassungskapazität. Die Ermittlung der Kapazitätswerte kann auf verschiedene Weise erfolgen. Bevorzugt ist ein dem Fachmann an sich bekanntes Vorgehen, bei dem die jeweilige Kapazität als Teil eines R/C-Schwingkreises geschaltet wird, dessen Resonanzfrequenz f gemessen und so der veränderliche Kapazitätswert C ermittelt wird.

Dann wird zwischen der ersten Erfassungskapazität und der Referenzkapazität ebenso wie zwischen der zweiten Erfassungskapazität und der Referenzkapazität jeweils die Differenz d1, d2 gebildet. Die so erhaltenen Differenzwerte d1, d2 werden in einer Entscheidungslogik 34 verglichen und basierend hierauf ein Ausgangssignal A sowie zusätzlich ein Fehlersignal F abgegeben.

Die Entscheidungslogik 34 verarbeitet die Differenzsignale d1, d2. Diese werden jeweils mit einem in der Entscheidungslogik 34 festgelegten Schwellenwert verglichen. Liegen beide Differenzen d1, d2 unterhalb des Schwellenwertes, so zeigt dies an, dass derzeit kein Target 14 im Erfassungsbereich 18 angeordnet ist. Denn die Elektroden 24a, 24b, 26 sind von gleicher Form und relativen Anordnung zur Gegenelektrode 22, so dass sich gleiche Kapazitätswerte und somit Differenzen d1, d2 von im Wesentlichen Null ergeben. Entsprechend gibt die Entscheidungslogik ein Ausgangssignal A aus, das die Abwesenheit des Targets 14 anzeigt.

Liegen beide Differenzsignale d1, d2 oberhalb der Schwelle, so zeigt dies die Anordnung des Targets 14 innerhalb des Erfassungsbereiches 18 an. Denn durch die Zwischenelektroden 30a, 30b des Targets 14 ergeben sich die folgenden Kapazitätsdifferenzen:

$$d_1 = \varepsilon_0 h(b_{Target}/(d-d_{Target})-b_{Target}/d),$$

wobei h die Höhe der Elektroden, d der Plattenabstand im Spalt 16, $d_{Target}$ die Dicke des Targets 14 und $b_{Target}$ die Breite des Targets 14 bezeichnen.

Bei entsprechender Wahl der oben genannten Parameter, insbesondere einer geeigneten Abstimmung der Dicke des Targets 14 an den Erfassungsteilen 30a, 30b bezogen auf die Spaltbreite d können hinreichend große Differenzsignale d1, d2 bei Anwesenheit des Targets 14 erzeugt werden, so dass durch eine entsprechend gewählte Schwelle Störsignale unterhalb dieser Schwelle nicht zu einer Fehldetektion führen.

Wenn die Entscheidungslogik feststellt, dass beide Differenzsignale d1, d2 oberhalb der Schwelle liegen, also beide Erfassungskapazitäten die Anwesenheit des Targets 14 bestätigen, gibt sie ein entsprechendes Ausgangssignal A aus.

Dabei werden Störsignale, die durch externe Felder verursacht werden, in der Regel gleichmäßig auf die Referenz- und Erfassungskapazitäten wirken und somit durch die Differenzbildung systembedingt eliminiert.

Durch die dargestellte Anordnung von drei Kapazitäten, bei denen zumal die Referenzkapazität zwischen der ersten und zweiten Erfassungskapazität angeordnet ist, ist zudem eine Erkennung von Fehlerzuständen und insbesondere von Manipulationsversuchen möglich. Insbesondere kann das Einbringen von Fremdkörpern von oben in den Spalt 16, d.h. mit einer Bewegung quer zu dessen Längsrichtung sicher erkannt werden, weil dies zunächst zu einer deutlichen Kapazitätsveränderung der oberen Erfassungskapazität zwischen den Elektroden 24a, 22 führt, aber zunächst nicht zu einer Veränderung an der zweiten, unteren Erfassungskapazität. Zu diesem Zweck überwacht die Auswertungslogik 34 auch ein deutliches Abweichen der Differenzsignale d1, d2 voneinander. Hierzu bildet sie erneut die Differenz und signalisiert im Fall einer Abweichung, die oberhalb einer Fehlerschwelle liegt, einen Fehlerzustand durch das Fehlersignal F.

Zudem kann die Entscheidungslogik auch weitergehend die Plausibilität der Differenzsignale d1, d2 prüfen. Durch die Zwischenelektroden des Targets 14 kann sich der Kapazitätswert der Erfassungskapazität nur erhöhen. Zeigt sich, dass die Referenzkapazität einen höheren Kapazitätswert aufweist als eine der Erfassungskapazitäten, so kann ebenfalls ein Fehlerzustand signalisiert werden.

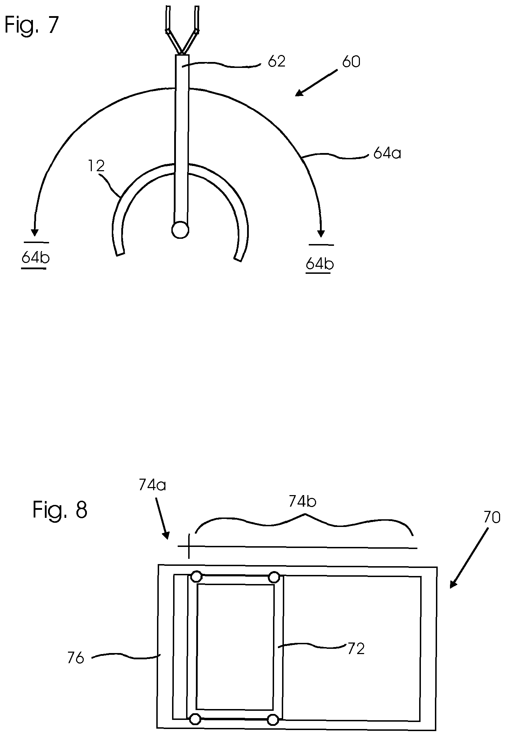

Der gezeigte Aufbau des Targets 14, bei dem wie in Figur 2 gezeigt die Anordnung und die Abmessungen der Erfassungsteile 30a, 30b des Targets 14 ebenso wie des Referenzteils 32 mit der Anordnung der Elektroden übereinstimmt, stellt eine Art Kodierung dar, die zudem eine Täuschung der Erfassungsvorrichtung durch improvisierte Targets weitgehend vermeidet. Hierzu dient auch die aus Figur 2 ersichtliche Anordnung des Targets 14 in "schwebender" Anordnung, also so, dass das Target 14 in Tiefenrichtung des Schlitzes (oben/unten in Fig. 7, Fig. 2)nicht geführt ist. Wie dargestellt ist die Tiefe des Schlitzes 16 größer als die Länge des Targets 14, so dass dieses ohne Anbringung an dem Bewegungsglied 11 nach unten rutschen würde, was als Fehlerzustand in der Entscheidungslogik 34 erkannt werden kann.

Somit kann durch Auswertung der Differenzsignale d1, d2 ein Ausgangssignal A als Logiksignal ausgegeben werden, dass sicher die Anwesenheit des Targets 14 im Erfassungsbereich 18 anzeigt. Zeigt die Auswertung von d1, d2 hingegen einen unzulässigen Betriebszustand an kann dies durch ein Fehlersignal F signalisiert werden.

Dabei ist der Positionsschalter 10 wie in Fig. 4 schematisch dargestellt prinzipbedingt für einen modularen Aufbau geeignet, bei dem einzelne Sensorleisten 12a, 12b parallel hintereinander geschaltet werden. Da sich parallele Kapazitäten addieren, ergibt sich durch die parallele Verschaltung mehrere Sensorleisten 12a, 12b eine proportionale Erhöhung der einzelnen Kapazitäten. Durch die Differenzbildung wird diese wieder aufgehoben, so dass für dasselbe Target 14 stets dieselben Detektionsschwellen verwendet werden können, unabhängig von der Länge und Anzahl der Sensorleisten 12.

Ein Positionsschalter wie vorstehend beschrieben kann in einer Vielzahl von Anwendungen eingesetzt werden, insbesondere im Bereich der Automatisierungs- und Sicherheitstechnik.

Als ein erstes Beispiel zeigt Fig.5 einen Gabelstapler 40 mit einer in der Höhe verfahrbaren Gabel 42. Die Gabel 42 als Bewegungsglied ist mit einem Target 14 (nicht dargestellt) verbunden, dass in einem Schlitz (ebenfalls nicht gezeigt) am Hubgerüst des Gabelstaplers 40 beweglich ist und sich beim Heben der Gabel 42 darin entsprechend bewegt.

Für die jeweilige Höhe der Hubgabel 42 sind wie in Fig. 5 skizzenhaft dargestellt ein unterer Bereich 44a und ein oberer Bereich 44b definiert. Der Sensorbereich 18 der Sensorleiste 12 am Hubgerüst (nicht dargestellt) wird so ausgelegt, dass er dem Bewegungsbereich des Targets 14 bei Anordnung der Hubgabel 42 im unteren Bereich 44a entspricht. So kann anhand des Ausgangssignals A sicher festgestellt werden, ob sich die Hubgabel 42 in diesem unteren Bereich 44a befindet. Dieses Signal kann dann in der Steuerung des Gabelstaplers 40 verwendet werden, um eine höhere Fahrgeschwindigkeit freizugeben. Ist die Hubgabel 42 weiter angehoben und befindet sich im oberen Bereich 44b, dann erfolgt keine Freigabe durch das Ausgangssignal A des Positionsschalters 10 und die Fahrt des Gabelstaplers 40 kann aus Sicherheitsgründen nur gedrosselt erfolgen.

Eine Manipulation diese Sicherheitsvorrichtung durch Bedienpersonal ist wie bereits dargestellt weitgehend ausgeschlossen.

Fig. 6 zeigt als weiteres Anwendungsbeispiel eine Förder- bzw. Transportvorrichtung, hier in Form einer Laufkatze 42 die sich an einem Träger innerhalb eines Arbeitsbereiches 54a bewegt, an den sich Endbereiche 54b anschließen. Entlang des Trägers ist eine Sensorleiste 12 (nicht dargestellt) angebracht und die Laufkatze 42 als Bewegungsglied ist mit einem Target 14 (ebenfalls nicht dargestellt) so gekoppelt, dass dieses sich bei Bewegung der Laufkatze 42 im Schlitz verschiebt.

Der sichere Arbeitsbereich 54a der Laufkatze 42 entspricht dem Erfassungsbereich 18 der Sensorleiste. Durch das Ausgangssignal A erfolgt eine Freigabe, solange sich die Laufkatze 42 innerhalb des Arbeitsbereiches 54a befindet.

Gerät die Laufkatze 42 in die Endbereiche 54b, so wird dies anhand des Ausgangssignals A des Positionsschalters 10 erkannt und die Laufkatze 42 wird angehalten. Somit wirkt der Positionsschalter 10 als sicherer Endlagenschalter für die Laufkatze 42.

Im Beispiel von Fig. 7 bewegt sich ein Schwenkarm 62 in einem erlaubten Schwenkbereich (Arbeitsbereich) 64a, an den sich Endbereiche 64b anschließen, in die der Arm 62 aus Sicherheitsgründen nicht verschwenken soll. Die Sensorleiste 12 ist wie dargestellt kreisförmig ausgebildet; der Erfassungsbereich 18 entspricht dem Arbeitsbereich 64a. Der Arm 62 als Bewegungsglied ist mit einem Target (nicht dargestellt) gekoppelt, dass sich innerhalb der Sensorleiste 12 bewegt. Anhand des Ausgangssignals A kann so stets festgestellt werden, dass sich der Arm 62 innerhalb des erlaubten Arbeitsbereiches 64a befindet. Bleibt das entsprechende Freigabesignal aus, weil sich der Arm 62 in die nicht sicheren Bereiche 64b bewegt hat, so kann dies signalisiert und der weitere Betrieb ggf. unterbrochen werden.

Fig. 8 zeigt schließlich die Bereichserfassung einer Schiebetür 72 innerhalb eines Rahmens 76. Am Rahmen 76 ist eine Sensorleiste 12 und an der Tür 72 als Bewegungsglied ein Target 14 darin befestigt (beide nicht dargestellt). Der Erfassungsbereich der Sensorleiste 12 entspricht dabei einem Schließbereich 74a.

Mit dem Positionsschalter 10 ist es so möglich, eine Schließstellung der Schiebetür 72 zu detektieren, d.h. eine Stellung innerhalb des Schließbereiches 74a. Im Gegensatz zu bekannten einfachen Sensoren, die lediglich feststellen können, ob die Tür 72 vollständig geschlossen ist, kann der Schließbereich 74b so festgelegt sein, dass auch ein Schließen der Tür bis auf einen kleinen Luftspalt schon für eine Freigabe sorgt.

Bei Verwendung einer solchen Anordnung bspw. zum Schutz einer Maschine in der Automatisierungstechnik kann die Maschine schneller wieder anlaufen, was zu einer Steigerung der Produktivität führen kann. Ebenso kann der Spalt auch für eine kontrollierte Belüftung einer luftdicht verschlossenen Arbeitszelle genutzt werden.

Nachdem vorstehend eine Ausführungsform eines Positionsschalters sowie verschiedene Anwendungen hiervon beschrieben worden sind, wird der Fachmann erkennen, dass im Rahmen der Erfindung hiervon Abweichungen und weitere Verwendungen möglich sind. Insbesondere können die in der Entscheidungslogik 34 verwendeten Schwellen, d.h. einerseits die Fehlerschwelle zum Anzeigen eines Fehlerzustands F und andererseits die Erkennungsschwelle für die Differenzsignale d1, d2, oberhalb derer das Target 14 erkannt wird, statt einer festen Vorgabe auch einstellbar sein. Insbesondere kann eine Teaching-Funktion sinnvoll sein, bei der die effektiven Kapazitätswerte bzw. Differenzen d1, d2 mit und ohne Target gemessen und gespeichert werden um eine geeignete, bspw. mittig dazwischenliegende Schwelle zu definieren.

Zusätzlich zu den dargestellten Elektroden und Kapazitäten können weitere Elektroden und Kapazitäten vorgesehen sein und ausgewertet werden. Hierdurch kann einerseits eine vollständige Redundanz gewährleistet sein, wenn dies aus Sicherheitsgründen erforderlich ist. Andererseits können die jeweils gemessenen Signale zusätzlich miteinander verglichen und so plausibilisiert werden, um noch sicherer gegenüber Fehlfunktionen und Manipulationen zu sein.

In der konkreten Ausgestaltung eines Positionsschalters 10 kann die Auswertungsschaltung 28 direkt an der Sensorleiste 12 vorgesehen sein. Bspw. kann die Schaltung 28 seitlich am Erfassungsbereich 18 angeordnet sein, wobei die Elektrode 22 als Abschirmung dient.

**Patentansprüche**

1. Positionsschalter zur Erfassung eines beweglichen Targets (14) innerhalb eines Erfassungsbereiches (18) mit

   - einem Target (14), das in einem Spalt (16) verschiebbar ist mindestens innerhalb eines Erfassungsbereiches (18),
   - mindestens einer Referenzelektrode (26) und mindestens einer ersten Erfassungselektrode (24a), wobei die Referenzelektrode und die erste Erfassungselektrode (24a) jeweils über den Spalt (16) mit mindestens einer Gegenelektrode (22) eine Referenzkapazität und eine erste Erfassungskapazität bilden,
   - wobei das Target (14) mindestens einen Referenzteil (32) und mindestens einen ersten Erfassungsteil (30a) aufweist, wobei der Referenzteil der Referenzkapazität und der erste Erfassungsteil der ersten Erfassungskapazität zugeordnet ist, und wobei der Referenzteil (32) und der erste Erfassungsteil (30a, 30b) die jeweils zugeordnete Kapazität bei Anordnung des Targets (14) im Spalt (16) zwischen den Elektroden unterschiedlich beeinflusst,
- und mit einer Auswertungsschaltung, an die mindestens die Referenzkapazität und erste Erfassungskapazität angeschlossen ist, und die ein Erfassungssignal (A) abgibt, das mindestens durch Bildung der Differenz (d1, d2) von Kapazitätswerten der Referenzkapazität und ersten Erfassungskapazität ermittelt wird.

2. Positionsschalter nach Anspruch 1, bei dem

   - mindestens eine zweite Erfassungselektrode (24b) vorgesehen ist, wobei die erste und zweite Erfassungselektrode (24a, 24b) jeweils über den Spalt (16) mit mindestens der Gegenelektrode (22) mindestens eine erste und eine zweite Erfassungskapazität bilden,
   - und das Target (14) mindestens einen zweiten Erfassungsteil (30b) aufweist, wobei der erste Erfassungsteil (30a) der ersten Erfassungskapazität und der zweite Erfassungsteil (30b) der zweiten Erfassungskapazität zugeordnet ist,
   - wobei die Erfassung des Targets (14) in der Auswertungsschaltung mindestens durch Bildung einer ersten Differenz (d1) von Kapazitätswerten der Referenzkapazität und der ersten Erfassungskapazität, und durch Bildung einer zweiten Differenz (d2) von Kapazitätswerten der Referenzkapazität und der zweiten Erfassungskapazität erfolgt.

3. Positionsschalter nach Anspruch 2, bei dem

   - die Auswertungsschaltung einen Vergleich der Kapazitätswerte der ersten und der zweiten Erfassungskapazität oder einen Vergleich der Differenzwerte (d1, d2) vornimmt,
   - und bei einer Abweichung oberhalb einer Fehlerschwelle einen Fehlerzustand meldet.

4. Positionsschalter nach einem der Ansprüche 2, 3, bei dem

   - die Referenzelektrode (26) zwischen der ersten und zweiten Erfassungselektrode (24a, 24b) angeordnet ist.

5. Positionsschalter nach einem der vorangehenden Ansprüche, bei dem

   - eine gemeinsame Basiselektrode (22) als Gegenelektrode für die Referenz- und Erfassungselektrode vorgesehen ist.

6. Positionsschalter nach einem der vorangehenden Ansprüche, bei dem

   - die Referenzkapazität ohne Target (14) im Wesentlichen den gleichen Kapazitätswert aufweist wie die erste Erfassungskapazität bzw. die erste und zweite Erfassungskapazität.

7. Positionsschalter nach einem der vorangehenden Ansprüche, bei dem

   - die Referenzelektrode (26) und die erste Erfassungselektrode (24a) bzw. die erste und zweite Erfassungselektrode (24a, 24b) jeweils als Streifen gleicher Form und Abmessungen ausgebildet sind, die sich in Längrichtung des Spaltes (16) erstrecken.

8. Positionsschalter nach einem der vorangehenden Ansprüche, bei dem

   - der Erfassungsteil (30a, 30b) des Targets (14) eine Zwischenelektrode aufweist, so dass durch Anordnung der Zwischenelektrode im Spalt (16) der Kapazitätswert geändert wird.

9. Positionsschalter nach Anspruch 8, bei dem

   - im Referenzteil (32) des Targets keine Zwischenelektrode angeordnet ist.

10. Hubvorrichtung mit einer beweglichen Hubeinheit (42), bei der

    - ein Positionsschalter nach einem der vorangehenden Ansprüche vorgesehen ist,
    - wobei die Hubeinheit (42) mit dem Target (14) so gekoppelt ist, dass es sich bei Bewegung der Hubeinheit (42) entlang des Spaltes (16) bewegt,
    - und wobei mittels der Auswertungsschaltung (28) festgestellt wird, ob sich die Hubeinheit (42) in einem bestimmten, durch den Erfassungsbereich (18) festgelegten Höhenbereich (44a, 44b) befindet.

11. Fördervorrichtung mit einem beweglichen Element (42), bei dem

    - ein Positionsschalter nach einem der Ansprüche 1 - 9 vorgesehen ist,
    - wobei das bewegliche Element (42) mit dem Target (14) so gekoppelt ist, dass sich bei Bewegung des Elements (42) das Target (14) entlang des Spaltes (16) bewegt,
    - und wobei mittels der Auswertungsschaltung (28) festgestellt wird, ob sich das bewegliche Element (42) in einem bestimmten, durch den Erfassungsbereich festgelegten Fahrbereich (54a, 54b) befindet.

**12.** Vorrichtung mit einem Schwenkarm (62), bei der

- ein Positionsschalter nach einem der Ansprüche 1 - 9 vorgesehen ist, wobei sich der Spalt(16) entlang einer bogenförmigen Bahn erstreckt,
- wobei der Schwenkarm (62) mit dem Target (14) so gekoppelt ist, dass sich beim Schwenken des Arms (62) das Target (14) entlang des Spaltes (16) bewegt,
- und wobei mittels der Auswertungsschalung (28) festgestellt wird, ob sich der Schwenkarm in einem bestimmten, durch den Erfassungsbereich festgelegten Schwenkbereich (64a) befindet.

**13.** Vorrichtung mit einer beweglichen Tür, bei der

- ein Positionsschalter nach einem der Ansprüche 1 - 9 vorgesehen ist,
- wobei die Tür (72) mit dem Target (14) so gekoppelt ist, dass sich bei Bewegung der Tür (72) das Target (14) entlang des Spaltes (16) bewegt, H das
- und wobei mittels der Auswertungsschaltung (28) festgestellt wird, ob sich die Tür (72) in einem bestimmten, durch den Erfassungsbereich festgelegten Öffnung- oder Schließbereich (74a, 74b) befindet.

**14.** Verriegelungsvorrichtung mit einem beweglichen Bolzen, bei der

- ein Positionsschalter nach einem der Ansprüche 1 -9 vorgesehen ist,
- wobei der Bolzen als Target 14 ausgebildet und so angeordnet ist, dass er sich bei Bewegung zwischen einer Offenstellung und einer Riegelstellung entlang des Spaltes (16) bewegt,
- und wobei mittels der Auswertungsschaltung (28) festgestellt wird, ob sich der Bolzen in der durch den Erfassungsbereich festgelegten Riegelstellung befindet.

**Claims**

**1.** A position switch for detecting a moving target (14) within a detection area (18) with

- a target (14) that is displaceable in a slot (16) at least within a detection area (18),
- at least one reference electrode (26) and at least one first detection electrode (24a), wherein the reference electrode and the first detection electrode (24a) respectively form a reference capacity and a first detection capacity via the slot (16) with at least one counter electrode (22),

- wherein the target (14) has at least one reference part (32) and at least one first detection part (30a), wherein the reference part is assigned to the reference capacity and the first detection part is assigned to the first detection capacity, and wherein the reference part (32) and the first detection part (30a, 30b) differently influence the respectively assigned capacity when the target (14) is arranged in the slot (16) between the electrodes,
- and with an evaluation circuit to which at least the reference capacity and first detection capacity is connected and which emits a detection signal (A) that is determined at least by forming the difference (d1, d2) of capacity values of the reference capacity and first detection capacity.

**2.** The position switch according to claim 1 in which

- at least one second detection electrode (24b) is provided, wherein the first and second detection electrode (24a, 24b) respectively form at least one first and one second detection capacity via the slot (16) with at least the counterelectrode (22),
- and the target (14) has at least one second detection part (30b), wherein the first detection part (30a) is assigned to the first detection capacity and the second detection part (30b) is assigned to the second detection capacity,
- wherein the detection of the target (14) in the evaluation circuit occurs at least by forming a first difference (d1) of capacity values of the reference capacity and the first detection capacity, and by forming a second difference (d2) of capacity values of the reference capacity and the second detection capacity.

**3.** The position switch according to claim 2 in which

- the evaluation circuit carries out a comparison of the capacity values of the first and the second detection capacity or a comparison of the difference values (d1, d2),
- and reports an error condition in the case of a deviation above an error threshold.

**4.** The position switch according to one of claims 2, 3 in which

- the reference electrode (26) is arranged between the first and second detection electrode (24a, 24b).

**5.** The position switch according to one of the preceding claims in which

- a common basis electrode (22) is provided as a counter electrode for the reference and detection electrode.

6. The position switch according to one of the preceding claims in which

- the reference capacity without the target (14) has basically the same capacity value as the first detection capacity or respectively the first and second detection capacity.

7. The position switch according to one of the preceding claims in which

- the reference electrode (26) and the first detection electrode (24a) or respectively the first and second detection electrode (24a, 24b) are each designed as strips in the same shape and dimensions that extend in the longitudinal direction of the slot (16).

8. The position switch according to one of the preceding claims in which

- the detection part (30a, 30b) of the target (14) has an intermediate electrode so that the capacity value is changed by arranging the intermediate electrode in the slot (16).

9. The position switch according to claim 8 in which

- there is no intermediate electrode arranged in the reference part (32) of the target.

10. A lifting device with a moving lifting unit (42) in which

- a position switch according to one of the preceding claims is provided,
- wherein the lifting unit (42) is linked to the target (14) so that it moves along the slot (16) when the lifting unit (42) moves,
- and wherein it is determined by means of the evaluation circuit (28) whether the lifting unit (42) is in a specific height area (44a, 44b) determined by the detection area (18).

11. A conveying device with a moving element (42) in which

- a position switch according to one of claims 1 - 9 is provided,
- wherein the moving element (42) is linked to the target (14) so that the target (14) moves along the slot (16) when the element (42) moves,
- and wherein it is determined by means of the evaluation circuit (28) whether the moving element (42) is in a specific operating area (54a, 54b) determined by the detection area.

12. A device with a swivel arm (62) in which

- a position switch according to one of claims 1 - 9 is provided, wherein the slot (16) extends along an arch-shaped path,
- wherein the swivel arm (62) is linked to the target (14) so that the target (14) moves along the slot (16) when the arm (62) swivels,
- and wherein it is determined by means of the evaluation circuit (28) whether the swivel arm is in a specific swivel area (64a) determined by the detection area.

13. A device with a moving door in which

- a position switch according to one of claims 1 - 9 is provided,
- wherein the door (72) is linked to the target (14) so that the target (14) moves along the slot (16) when the door (72) moves,
- and wherein it is determined by means of the evaluation circuit (28) whether the door (72) is in a specific opening or closing area (74a, 74b) determined by the detection area.

14. A locking device with a moving bolt in which

- a position switch according to one of claims 1 - 9 is provided,
- wherein the bolt is designed as a target (14) and is arranged so that it moves along the slot (16) when moving between an open position and a blocking position,
- and wherein it is determined by means of the evaluation circuit (28) whether the bolt is in the blocking position determined by the detection area.

**Revendications**

1. Capteur de position destiné à détecter une cible mobile (14) à l'intérieur d'une zone de détection (18), comprenant :

- une cible (14) déplaçable dans une fente (16) au moins à l'intérieur d'une zone de détection (18),
- au moins une électrode de référence (26) et au moins une première électrode de détection (24a), l'électrode de référence et la première électrode de détection (24a) formant respectivement une capacité de référence et une première capacité de détection avec au moins une contre-électrode (22) par le biais de la fente (16),
- dans lequel la cible (14) présente au moins une partie de référence (32) et au moins une première partie de détection (30a), où la partie de référence est attribuée à la capacité de référence et la première partie de détection est attribuée à la première capacité de détection, et où la partie de référence (32) et la première partie de détection (30a, 30b) influence différemment la capacité respectivement attribuée lors de la disposition de la cible (14) dans la fente (16) entre les électrodes,

- et comprenant un circuit d'évaluation auquel sont raccordées au moins la capacité de référence et la première capacité de détection, et lequel délivre un signal de détection (A) déterminé au moins par la formation de la différence (d1, d2) entre des valeurs de la capacité de référence et de la première capacité de détection.

**2.** Capteur de position selon la revendication 1, dans lequel

- il est prévu au moins une deuxième électrode de détection (24b), la première et la deuxième électrode de détection (24a, 24b) formant respectivement une première et une deuxième capacité de détection au moins avec la contre-électrode (22) par le biais de la fente (16),

- et la cible (14) présente au moins une deuxième partie de détection (30b), la première partie de détection (30a) étant attribuée à la première capacité de détection et la deuxième partie de détection (30b) étant attribuée à la deuxième capacité de détection,

- dans lequel la détection de la cible (14) dans le circuit d'évaluation est effectuée au moins par la formation d'une première différence (d1) de valeurs de capacité de la capacité de référence et de la première capacité de détection, et par la formation d'une deuxième différence (d2) de valeurs de capacité de la capacité de référence et de la deuxième capacité de détection.

**3.** Capteur de position selon la revendication 2, dans lequel

- le circuit d'évaluation effectue une comparaison des valeurs de capacité des première et deuxième capacités de détection ou une comparaison des valeurs de différence (d1, d2),

- et signale un état d'erreur en cas d'écart au-delà d'un seuil d'erreur.

**4.** Capteur de position selon l'une des revendications 2, 3, dans lequel

- l'électrode de référence (26) est disposée entre la première et la deuxième électrode de détection (24a, 24b).

**5.** Capteur de position selon l'une des revendications précédentes, dans lequel

- une électrode de base commune (22) est prévue en tant que contre-électrode pour l'électrode de référence et l'électrode de détection.

**6.** Capteur de position selon l'une des revendications précédentes, dans lequel

- la capacité de référence sans cible (14) présente quasiment la même valeur de capacité que la première capacité de détection ou les première et deuxième capacités de détection.

**7.** Capteur de position selon l'une des revendications précédentes, dans lequel

- l'électrode de référence (26) et la première électrode de détection (24a) ou les première et deuxième électrodes de détection (24a, 24b) sont respectivement conçues comme des bandes avec une forme et des dimensions similaires, lesquelles s'étendent dans la direction longitudinale de la fente (16).

**8.** Capteur de position selon l'une des revendications précédentes, dans lequel

- la partie de détection (30a, 30b) de la cible (14) présente une électrode intermédiaire, de telle façon que la disposition de l'électrode intermédiaire dans la fente (16) permet de modifier la valeur de capacité.

**9.** Capteur de position selon la revendication 8, dans lequel

- aucune électrode intermédiaire n'est disposée dans la partie de référence (32) de la cible.

**10.** Dispositif de levage avec une unité de levage mobile (42), dans lequel

- il est prévu un capteur de position selon l'une des revendications précédentes,

- où l'unité de levage (42) est accouplée de telle façon à la cible (14), que celle-ci se déplace le long de la fente (16) lors du déplacement de l'unité de levage (42),

- et où le circuit d'évaluation (28) permet de déterminer si l'unité de levage (42) se trouve dans une certaine plage de hauteur (44a, 44b) prédéfinie par la zone de détection (18).

**11.** Dispositif de transport avec un élément mobile (42), dans lequel

- il est prévu un capteur de position selon l'une des revendications 1 à 9,

- où l'élément mobile (42) est accouplé de telle façon à la cible (14), que la cible (14) se déplace le long de la fente (16) lors du déplacement de l'élément (42),

- et où le circuit d'évaluation (28) permet de déterminer si l'élément mobile (42) se trouve dans une certaine zone de conduite (54a, 54b) prédéfinie par la zone de détection.

**12.** Dispositif avec un bras pivotant (62), dans lequel

- il est prévu un capteur de position selon l'une des revendications 1 à 9, dans lequel la fente (16) s'étend le long d'une voie en forme d'arc,

- où le bras pivotant (62) est accouplé de telle façon à la cible (14), que la cible (14) se déplace le long de la fente (16) lors du pivotement du bras (62),

- et où le circuit d'évaluation (28) permet de déterminer si le bras pivotant se trouve dans une certaine plage de pivotement (64a) prédéfinie par la zone de détection.

**13.** Dispositif avec une porte mobile, dans lequel

- il est prévu un capteur de position selon l'une des revendications 1 à 9,

- où la porte (72) est accouplée de telle façon à la cible (14), que la cible (14) se déplace le long de la fente (16) lors du mouvement de la porte (72),

- et où le circuit d'évaluation (28) permet de déterminer si la porte (72) se trouve dans une certaine plage d'ouverture ou de fermeture (74a, 74) prédéfinie par la zone de détection.

**14.** Dispositif de verrouillage avec un boulon mobile, dans lequel

- il est prévu un capteur de position selon l'une des revendications 1 à 9,

- où le boulon est conçu comme étant la cible (14) et disposé de manière à se déplacer le long de la fente (16) lors du mouvement entre une position ouverte et une position verrouillée,

- et où le circuit d'évaluation (28) permet de déterminer si le boulon se trouve dans la position de verrouillage prédéfinie par la zone de détection.

Fig. 1

Fig. 2

Fig. 3

EP 2 775 625 B1

10

12a

12b

Fig. 4

44b

44a

42

40

Fig. 5

50

54b

54a

54b

42

Fig. 6

Fig. 7

62

60

12

64a

64b

64b

Fig. 8

74a

74b

70

76

72

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10207017 A1
- DE 102007038225 A1
- DE 10051292 A1

- EP 1152533 A1
- US 20090086879 A1